# EUROPEAN PATENT APPLICATION

(11) **EP 4 672 243 A1**
(43) Date of publication of application: **31.12.2025**
(21) Application number: 25174674.9
(22) Date of filing: 07.05.2025
(51) Int. Cl.: G11C 5/06, H01L 23/00

(54) **CONTAMINATION FREE COPPER INTERCONNECT ON ALUMINUM PAD**

(30) Priority: 27.06.2024 US 202418757300
(71) Applicant: INTEL Corporation, Santa Clara, CA 95054 (US)
(72) Inventor: AHMED, Shafaat, Albuquerque, 87113 (US); DENARDIS, Darren, Albuquerque, 87122 (US)
(74) Representative: Goddar, Heinz J.

(57) **Abstract**

Embodiments disclosed herein include an apparatus that comprises a pad, and the pad comprises aluminum. In an embodiment, a liner is on a sidewall of the pad, and the liner extends past a surface of the pad. In an embodiment, a first layer is over the pad, and the first layer comprises copper. In an embodiment, a second layer is over the first layer, and the second layer is a dielectric material. In an embodiment, a via that passes through the second layer and contacts the first layer.

## Description

### BACKGROUND

In advanced packaging, hybrid bonding is a key enabler for higher bandwidth, increased power, and improved signal integrity. Hybrid bonding includes the direct metal-to-metal bonding of pads in addition to dielectric-to-dielectric bonding adjacent to the pads. Due to the complexity of processes, such hybrid bonding is typically limited to copper-to-copper bonding and/or fabrication of copper interconnects. In some instances, the incoming wafer may include aluminum pads and/or interconnects.

However, the incorporation of aluminum pads leads to several issues. One issue is that processing that involves aluminum can lead to contamination of the dry etching tool used for subsequent copper based processes. Wet clean processing, which is used to remove dry etch organometallic polymers, may also comprise aluminum. Accordingly, it is difficult to integrate systems with incoming aluminum pads into existing process flows. Further, reliable direct bonding between copper and aluminum does not yield interconnects that are as reliable and as high performing as copper-to-copper interconnects.

### BRIEF DESCRIPTION OF THE DRAWINGS

Figure 1A is a cross-sectional illustration of a die that comprises an aluminum pad, in accordance with an embodiment.
Figure 1B is a cross-sectional illustration of a die that comprises an aluminum pad with aluminum vias, in accordance with an embodiment.
Figure 2A is a cross-sectional illustration of a die with an aluminum pad that includes a cap between a copper pad and the aluminum pad, in accordance with an embodiment.
Figure 2B is a zoomed in illustration of the aluminum pad, the cap, a via, and the copper pad, in accordance with an embodiment.
Figure 2C is a zoomed in illustration of the aluminum pad, the cap, a via, and the copper pad with a non-planar interface between the aluminum pad and the cap, in accordance with an embodiment.
Figures 3A - 3I are cross-sectional illustrations depicting a process for forming a cap layer over an aluminum pad, in accordance with an embodiment.
Figures 4A and 4B are cross-sectional illustrations depicting a hybrid bonding process between a die with an aluminum pad and a package substrate, in accordance with an embodiment.
Figure 5 is a flow diagram of a process for forming a cap layer over an aluminum pad, in accordance with an embodiment.
Figure 6 is a cross-sectional illustration of an electronic system with a die that is hybrid bonded to a package substrate, where the die has an aluminum pad and a cap layer, in accordance with an embodiment.
Figure 7 is a schematic of a computing device built in accordance with an embodiment.

### EMBODIMENTS OF THE PRESENT DISCLOSURE

Described herein are copper to aluminum hybrid bonded interconnects in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

As noted above, some dies are formed with aluminum pads. The aluminum pads provide complications with subsequent process when hybrid bonding is desired. For example, the presence of aluminum during dry etching processes may result in the contamination of etching tools that are otherwise used for copper based processing. Accordingly, it is not currently feasible to integrate such incoming dies into existing hybrid bonding process flows. Additionally, the aluminum-to-copper hybrid bond may not provide the same reliability and/or performance as a copper-to-copper hybrid bond.

Accordingly, embodiments disclosed herein may comprise the fabrication of additional layers over the aluminum pad in order to prevent subsequent exposure to the aluminum. The subsequent layers may also comprise copper in order to make a copper-to-copper interconnect bond in order to improve performance and/or reliability. In an embodiment, the structures overlying the aluminum pad may include a cap that comprises copper. In such an embodiment, the aluminum pad may be recessed below a top surface of a passivation layer for the aluminum pad. The cap may then be deposited into the recess over the aluminum pad. In an embodiment, a subsequent via and pad (which may also comprise copper) may be formed over the cap.

In an embodiment, an interface between the aluminum pad and the cap may be substantially planar. In other embodiments, the interface between the aluminum pad and the cap may be non-planar. Such a non-planar interface may improve the strength of the interface and allow for improved reliability.

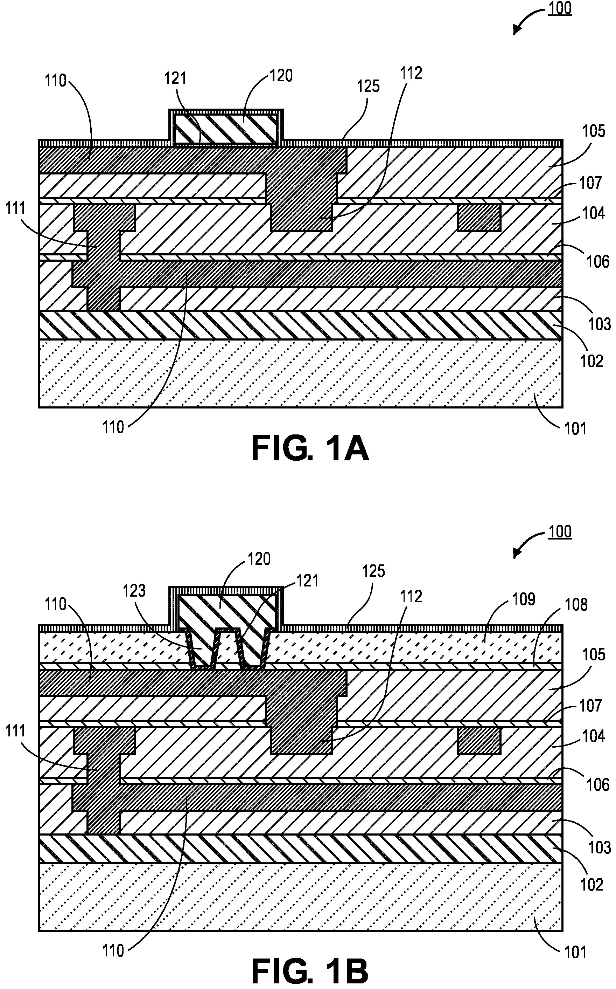

Referring now to Figure 1A, a cross-sectional illustration of a die 100 is shown, in accordance with an embodiment. In an embodiment, the die 100 may comprise a substrate 101. The substrate 101 may be a semiconductor substrate, such as a silicon substrate. During some or all of the fabrication processes described herein, the die 100 may be part of a complete wafer. That is, the substrate 101 may not be singulated into individual dies 100 during some or all of the fabrication processes described herein. In an embodiment, a front-end-of-line (FEOL) layer 102 may be provided on the substrate 101. The FEOL layer 102 may comprise transistor devices and/or the like (not individually shown). In an embodiment, one or more back-end-of-line (BEOL) layers and/or packaging layers may be provided over the FEOL layer 102. For example, the BEOL layers and/or the packaging layers may include dielectric layers 103, 104, and 105 which may be separated from each other with etchstop layers 106 and 107. The dielectric layers 103, 104, and 105 (and other dielectric layers described herein) may comprise any suitable dielectric material such as an oxide (e.g., silicon oxide), a nitride (e.g., silicon nitride), an oxynitride (e.g., silicon oxynitride), or the like. Some dielectric layers described herein may also comprise organic dielectric materials, such as organic buildup film or the like. In an embodiment, electrical routing (e.g., traces 110, vias 111, pads 112, etc.) may be embedded in the BEOL layers and/or the packaging layers.

In an embodiment, a pad 120 may be provided over one of the traces 110. In the embodiment shown in Figure 1A, the pad 120 may be directly provided over the trace 110 without an intervening via. The pad 120 may be separated from the trace 110 by a liner 121. The liner 121 may comprise one or more of titanium, nitrogen, tantalum, and/or the like. In an embodiment, the pad 120 may comprise aluminum. In some instances, the pad 120 may comprise substantially aluminum. For example, the pad 120 may comprise 75% aluminum by weight or more, 90% aluminum be weight or more, or 99% aluminum by weight or more. In some instances, the pad 120 may be approximately 100% aluminum by weight (which may include some trace amounts of other elements).

Since aluminum oxidizes rapidly in atmosphere, a passivation layer 125 may be provided over surfaces of the pad 120. The passivation layer 125 may comprise silicon and nitrogen (e.g., SiN). Due to the passivation layer 125, an etching process is used in order to subsequently expose the pad 120 for bonding. Particularly, a dry etching process is commonly used to remove the passivation layer 125. However, since the etching process will expose the underlying aluminum of the pad 120, the dry etching cannot be done in the same processing line that is used to process layers where copper will be exposed. Otherwise, the etching chamber will be contaminated with aluminum, which will significantly impact processing moving forward.

Referring now to Figure 1B, a cross-sectional illustration of another die 100 is shown, in accordance with an additional embodiment. The die 100 in Figure 1B is similar to the die 100 in Figure 1A, with the exception of the addition of vias 123 between the pad 120 and the trace 110. For example, an additional dielectric layer 109 may be provided over the etchstop layer 108. The vias 123 from the pad 120 to the trace 110 pass through a thickness of the dielectric layer 109. In an embodiment, the vias 123 may also comprise aluminum. For example, the amount of aluminum in the vias 123 may be substantially similar to the amount of aluminum in the pad 120. In some embodiments, the vias 123 may comprise substantially 100% aluminum (with only trace amounts of other elements). In an embodiment, the vias 123 may be separated from the dielectric layer 109 and the trace 110 by a liner 121. The liner 121 may comprise one or more of titanium, nitrogen, tantalum, and/or the like.

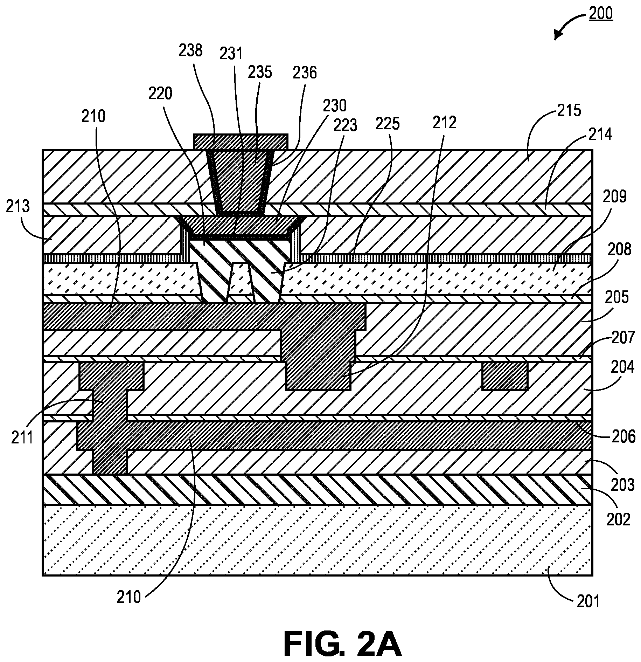

In order to make the dies 100 more compatible with existing process flows, embodiments disclosed herein may include the formation of additional copper layers over the aluminum pad 120. The additional copper layers may include a cap, a via, and a pad. The cap may be formed directly over the aluminum pad 120 after the aluminum pad is recessed. The via and pad may then be formed with traditional patterning and plating processes. Figures 2A - 2C provide different examples of the resulting structure.

Referring now to Figure 2A, a cross-sectional illustration of a die 200 is shown, in accordance with an embodiment. In an embodiment, the die 200 may comprise a substrate 201. The substrate 201 may be a semiconductor substrate, such as a silicon substrate. During some or all of the fabrication processes described herein, the die 200 may be part of a complete wafer. That is, the substrate 201 may not be singulated into individual dies 200 during some or all of the fabrication processes described herein. In an embodiment, an FEOL layer 202 may be provided on the substrate 201. The FEOL layer 202 may comprise transistor devices and/or the like (not individually shown). In an embodiment, one or more BEOL layers and/or packaging layers may be provided over the FEOL layer 202. For example, the BEOL layers and/or the packaging layers may include dielectric layers 203, 204, and 205 which may be separated from each other with etchstop layers 206, 207, and 208. In an embodiment, electrical routing (e.g., traces 210, vias 211, pads 212, etc.) may be embedded in the BEOL layers and/or the packaging layers.

In an embodiment, a pad 220 may be provided over one of the traces 210. The pad 220 may be electrically coupled to the trace 210 by one or more vias 223 that pass through a dielectric layer 209. While not shown, a liner (similar to liner 121) may be formed along the surfaces of the vias 223. Such a liner may comprise one or more of titanium, nitrogen, tantalum, and/or the like. In an embodiment, the pad 220 and the vias 223 may comprise aluminum. In some instances, the pad 220 and vias 223 may comprise substantially aluminum. For example, the pad 220 and vias 223 may comprise 75% aluminum by weight or more, 90% aluminum be weight or more, or 99% aluminum by weight or more. In some instances, the pad 220 and vias 223 may be approximately 100% aluminum by weight (which may include some trace amounts of other elements). While an example is show with vias 223, it is to be appreciated that die 200 may also include a pad 220 that is electrically coupled to the trace 210 without any intervening vias 223 (e.g., similar to the structure shown in Figure 1A). In another embodiment, the vias 223 may comprise one or more of aluminum, copper, cobalt, or tungsten.

Since aluminum oxidizes rapidly in atmosphere, a passivation layer 225 may be provided over some surfaces of the pad 220. The passivation layer 225 may comprise silicon and nitrogen (e.g., SiN). As shown, the passivation layer 225 has been removed from a top surface of the pad 220 in order to allow for contact with an overlying cap 230. The cap 230 may comprise copper. For example, the cap 230 may comprise 75% copper by weight or more, 90% copper be weight or more, or 99% copper by weight or more. In some instances, the cap 230 may be approximately 100% copper by weight (which may include some trace amounts of other elements). In some embodiments, the cap 230 may also comprise a seed layer and/or barrier layer 231. The seed layer and/or barrier layer 231 may comprise one or more of tantalum, nitrogen, copper, and/or the like. As shown, the top surface of the pad 220 may be recessed below a top surface of the passivation layer 225. As such, at least a portion of the cap 230 may also be lined by the passivation layer 225.

In an embodiment, an etchstop layer 214 may be provided over a dielectric layer 213 that surrounds at least some portions of the pad 220 and the cap 230. A via 235 may pass through the etchstop layer 214 and a dielectric layer 215 that is over the etchstop layer 214. The via 235 may also comprise copper. For example, a percentage of copper in the via 235 may be similar to a percentage of copper in the cap 230. The via 235 may also comprise a seed layer and/or barrier layer 236 that has a similar composition as the seed layer and/or barrier layer 231. In an embodiment, a pad 238 may be provided over the via 235. The pad 238 may also comprise a high percentage of copper or substantially all copper.

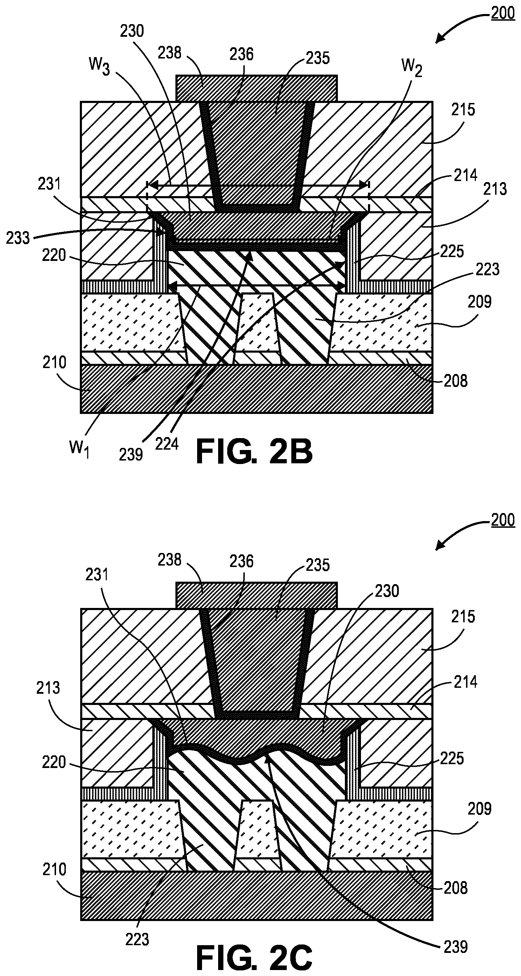

Referring now to Figure 2B, a zoomed in illustration of the interconnect within the die 200 is shown, in accordance with an embodiment. As shown, the pad 220 may have a first width W₁. The sidewalls 224 of the pad 220 may be contacted by the passivation layer 225. The cap 230 overlying the pad 220 may have a non-uniform width through a thickness of the cap 230. For example, the cap 230 may have a second width W₂ at the interface 239 between the cap 230 and the pad 220. In an embodiment, the second width W₂ may be substantially equal to the first width W₁. Further, the cap 230 may have a third width W₃ approximate to a top of the cap 230. The third width W₃ may be greater than the second width W₂. In an embodiment, a portion of the cap 230 with the second width W₂ may be lined by the passivation layer 225. In an embodiment, the interface 239 may be substantially planar.

In an embodiment, the cap 230 may have a sidewall 233 that is non-vertical through the entire thickness of the cap 230. For example, a first portion of the sidewall 233 may be substantially orthogonal to the interface 239, and a second portion of the sidewall 233 may be sloped. The slope of the sidewall 233 may be the result of an etching process used to recess the top surface of the pad 220, as will be described in greater detail below. In an embodiment, the top surface of the passivation layer 225 may also be sloped at the same angle as the second portion of the sidewall 233 as a result of the etching process used to recess the top surface of the pad 220.

Referring now to Figure 2C, a zoomed in cross-sectional illustration of the interconnect of the die 200 is shown, in accordance with an additional embodiment. In an embodiment, the die 200 in Figure 2C is similar to the die 200 in Figure 2B, with the exception of the interface 239. Instead of providing a planar interface 239, the interface 239 is non-planar. A non-planar interface 239 may be a result of the etching process used to recess the top surface of the pad 220. In the example shown in Figure 2C, the interface 239 has a wave pattern. Though, other non-planar interfaces 239 may also be present, such as a jagged interface 239, a high surface roughness interface 239, or any other interface 239 with a regular or irregular pattern. The use of such a non-planar interface 239 may provide enhanced reliability since the adhesion strength between the cap 230 and the pad 220 will be increased due to a larger surface area of the interface 239.

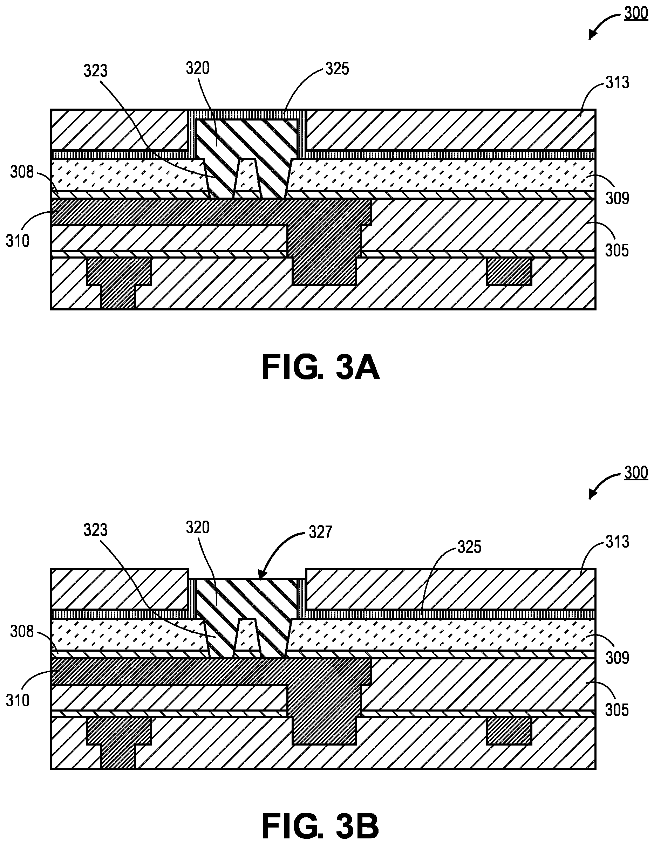

Referring now to Figures 3A - 3I, a series of cross-sectional illustrations depicting a process for forming a die 300 with an interconnect that comprises an aluminum pad with a copper cap over the aluminum pad is shown, in accordance with an embodiment. In the embodiments shown in Figures 3A - 3I, the aluminum pad 320 is coupled to an underlying trace 310 through vias 323. Though, in other embodiments, the aluminum pad 320 may be directly over the underlying trace 310, similar to the embodiment shown in Figure 1A.

Referring now to Figure 3A, a cross-sectional illustration of a portion of a die 300 is shown, in accordance with an embodiment. The illustrated portion of the die 300 includes upper dielectric layers, such as dielectric layers 305, 309, and 313 and etchstop layer 308. However, it is to be appreciated that underlying layers may include other BEOL layers, FEOL layers, a semiconductor substrate, and/or the like. For example, the underlying structure of the die 300 may be similar to any of the dies described in greater detail herein. In an embodiment, electrically conductive features such as traces 310, vias, pads, and/or the like may be embedded in and/or provided on any of the layers of the die 300.

In an embodiment, a pad 320 may be provided within the dielectric layer 313. The pad 320 may comprise aluminum. The pad 320 may comprise 75% aluminum by weight or more, 90% aluminum be weight or more, or 99% aluminum by weight or more. In some instances, the pad 320 may be approximately 100% aluminum by weight (which may include some trace amounts of other elements). The aluminum within the pad 320 may rapidly oxidize if left exposed. Accordingly, a passivation layer 325 may be provided over surfaces of the pad 320. The passivation layer 325 may comprise silicon and nitrogen (e.g., SiN) or the like. In an embodiment, the passivation layer 325 is deposited with a blanket deposition process. As such, the passivation layer 325 may be provided over the dielectric layer 309, along sidewalls of the pad 320, and over a top surface of the pad 320.

In an embodiment, one or more vias 323 may electrically couple the pad 320 to the underlying trace 310. The vias 323 may pass through the dielectric layer 309 and the etchstop layer 308. In an embodiment, the vias 323 may comprise aluminum as well. For example, a composition of the vias 323 may be substantially similar to a composition of the pad 320. In the illustrated embodiment, there is no liner between the vias 323 and the trace 310. Though, in other embodiments a liner (not shown) may be provided along sidewalls and a bottom surface of the vias 323, similar to the liner 121 described in greater detail herein. In another embodiment, the vias 323 may comprise one or more of aluminum, copper, cobalt, or tungsten.

Referring now to Figure 3B, a cross-sectional illustration of the portion of the die 300 after the passivation layer 325 is removed from a top surface of the pad 320 is shown, in accordance with an embodiment. In an embodiment, the removal of the portion of the passivation layer 325 exposes the top surface 327 of the pad 320. In an embodiment, the top surface 327 of the pad 320 is substantially coplanar with a top surface of the passivation layer 325 that extends up the sidewalls of the pad 320. In an embodiment, the passivation layer 325 may be removed with any suitable etching process, such as a dry etching process. During the etching process, the aluminum of the pad 320 may be exposed. Accordingly, the etching process may be implemented in an etching chamber that occurs outside of the traditional copper compatible etching process flow.

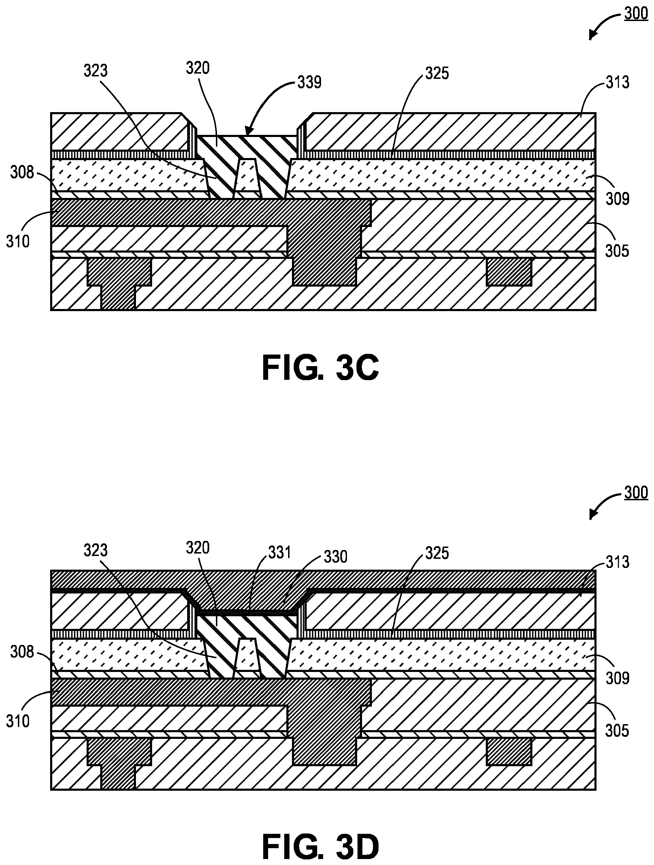

Referring now to Figure 3C, a cross-sectional illustration of the portion of the die 300 after the pad 320 is recessed is shown, in accordance with an embodiment. In an embodiment, the recessed surface 339 of the pad 320 may be below the top surface of the passivation layer 325 along the sidewalls of the pad 320. That is, a portion of the passivation layer 325 may extend past the recessed surface 339 of the pad 320. In the illustrated embodiment, the recessed surface 339 is substantially planar. Though, in other embodiments, the etching process may result in a non-planar recessed surface 339 such as other non-planar surfaces described in greater detail herein.

The etching process used to recess the pad 320 may also partially remove portions of the dielectric layer 313 and the passivation layer 325. For example, the passivation layer 325 and the dielectric layer 313 may have tapered portions. In an embodiment, the pad 320 may be etched with a dry etching process. After the dry etching process a wet clean may be used to remove polymer residue (e.g., organometallic polymers or the like) and/or any other residue. The wet clean process may be used to improve the cleanliness of the recessed surface 339 of the pad 320 in order to provide improved electrical connection to the subsequently formed cap 330.

Referring now to Figure 3D, a cross-sectional illustration of the portion of the die 300 after a layer of the cap 330 is formed over the pad 320 is shown, in accordance with an embodiment. In an embodiment, a seed layer and/or barrier layer 331 may be blanket deposited over the pad 320, the passivation layer 325 and the dielectric layer 313. The seed layer and/or barrier layer 331 may comprise one or more of tantalum, nitrogen, copper, and/or the like. The seed layer and/or barrier layer 331 may be deposited with any suitable deposition process, such as physical vapor deposition (PVD), chemical vapor deposition (CVD), atomic layer deposition (ALD), an electroless plating process, or the like.

After the seed layer and/or barrier layer 331 is deposited the cap 330 may be formed. The cap 330 may be formed with any suitable plating process, such as an electrolytic plating process. The cap 330 may comprise copper. For example, the cap 330 may comprise 75% copper by weight or more, 90% copper be weight or more, or 99% copper by weight or more. In some instances, the cap 330 may be approximately 100% copper by weight (which may include some trace amounts of other elements). The cap 330 may fill the opening in the dielectric layer 313 over the pad 320 and cover a top surface of the dielectric layer 313. In an embodiment, a reference to the cap 330 may also refer to the seed layer and/or barrier layer 331. That is, when the cap 330 is described as directly contacting the pad 320, it is to be appreciated that a cap 330 may include a seed layer and/or barrier layer 331 that is provided between the bulk copper of the cap 330 and the aluminum pad 320.

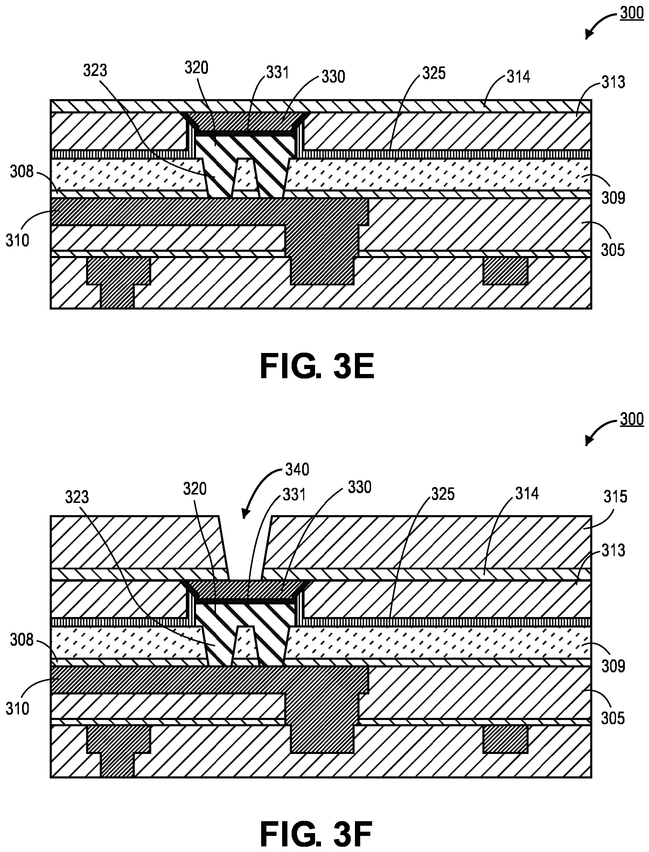

Referring now to Figure 3E, a cross-sectional illustration of the portion of the die 300 after the cap 330 is recessed and an etchstop layer 314 is deposited over the cap 330 and the dielectric layer 313 is shown, in accordance with an embodiment. In an embodiment, the cap 330 (and portions of the seed layer and/or barrier layer 331) may be recessed with a chemical mechanical planarization (CMP) process or the like. The recessing may result in the removal of the cap 330 outside of the opening in the dielectric layer 313 over the pad 320. As shown, the resulting cap 330 may also be at least partially lined by the passivation layer 325. That is, the passivation layer 325 may extend up a portion of a sidewall of the cap 330. The sidewall portion of the cap 330 that is contacted by the passivation layer 325 may be substantially vertical (i.e., substantially orthogonal to a top surface of the pad 320). The sidewall portion of the cap 330 above the passivation layer 325 (that contacts the dielectric layer 313) may be tapered in some embodiments. For example, a width of the cap 330 at a bottom of the cap 330 may be smaller than a width of the cap 330 at a top of the cap 330.

In an embodiment, the etchstop layer 314 may comprise any suitable dielectric material. For example, the etchstop layer 314 may comprise one or more of silicon, carbon, and nitrogen (e.g., SiCN). The etchstop layer 314 may be deposited with any suitable deposition process, such as a CVD process or the like.

Referring now to Figure 3F, a cross-sectional illustration of the portion of the die 300 after an additional dielectric layer 315 is applied and a via opening 340 is formed is shown, in accordance with an embodiment. In an embodiment, the dielectric layer 315 may be applied with a CVD process, a PVD process, a lamination process, or the like. The via opening 340 may be provided through the dielectric layer 315 and the etchstop layer 314. At this point, the etching process will only expose the copper of the cap 330. That is, the aluminum of the pad 320 is protected by the cap 330. As such, a dry etching process used to form the via opening 340 may be implemented in a processing chamber that is used for other copper based processes. In an embodiment, the via opening 340 is positioned to expose a portion of the cap 330.

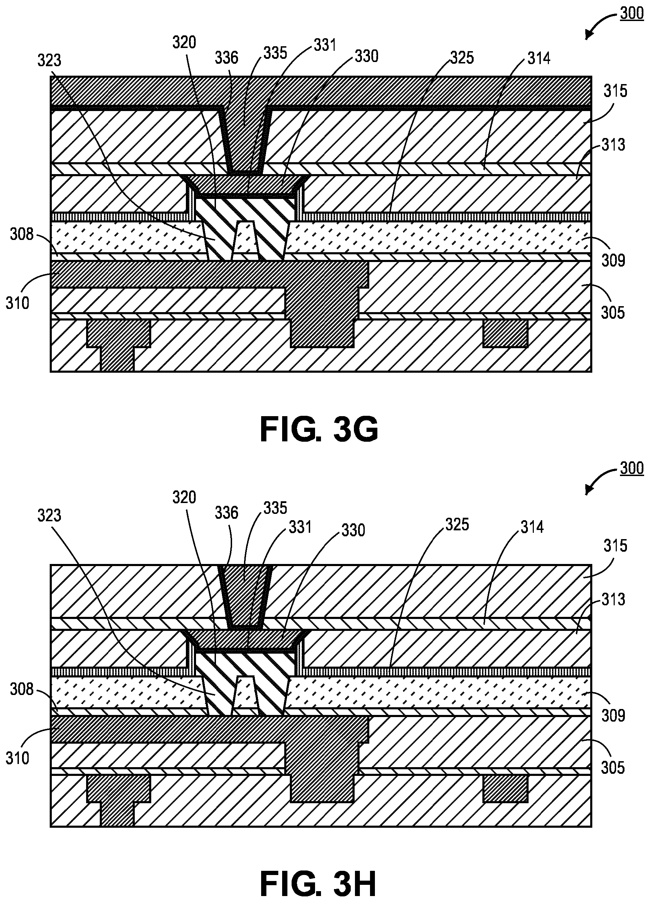

Referring now to Figure 3G, a cross-sectional illustration of the portion of the die 300 after the via 335 is formed is shown, in accordance with an embodiment. In an embodiment, a seed layer and/or barrier layer 336 may be blanket deposited over the cap 330, sidewalls of the via opening 340, and the dielectric layer 315. The seed layer and/or barrier layer 336 may comprise one or more of tantalum, nitrogen, copper, and/or the like. The seed layer and/or barrier layer 336 may be deposited with any suitable deposition process, such as PVD, CVD, ALD, an electroless plating process, or the like.

After the seed layer and/or barrier layer 336 is deposited the via 335 may be formed. The via 335 may be formed with any suitable plating process, such as an electrolytic plating process. The via 335 may comprise copper. For example, the via 335 may have a composition that is similar to the composition of the cap 330. The plating for the via 335 may fill the via opening 340 and cover a top surface of the dielectric layer 315. In an embodiment, a reference to the via 335 may also refer to the seed layer and/or barrier layer 336. That is, when the via 335 is described as directly contacting the cap 330, it is to be appreciated that the via 335 may include a seed layer and/or barrier layer 336 that is provided between the bulk copper of the cap 330 and the bulk copper of the via 335.

Referring now to Figure 3H, a cross-sectional illustration of the portion of the die 300 after the overburden from the deposition of copper for the vias 335 is removed is shown, in accordance with an embodiment. For example, the overburden may be removed with a CMP process or the like. The CMP process may also remove portions of the seed layer and/or barrier layer 336 over the dielectric layer 315. As such, portions of the dielectric layer 315 are exposed again.

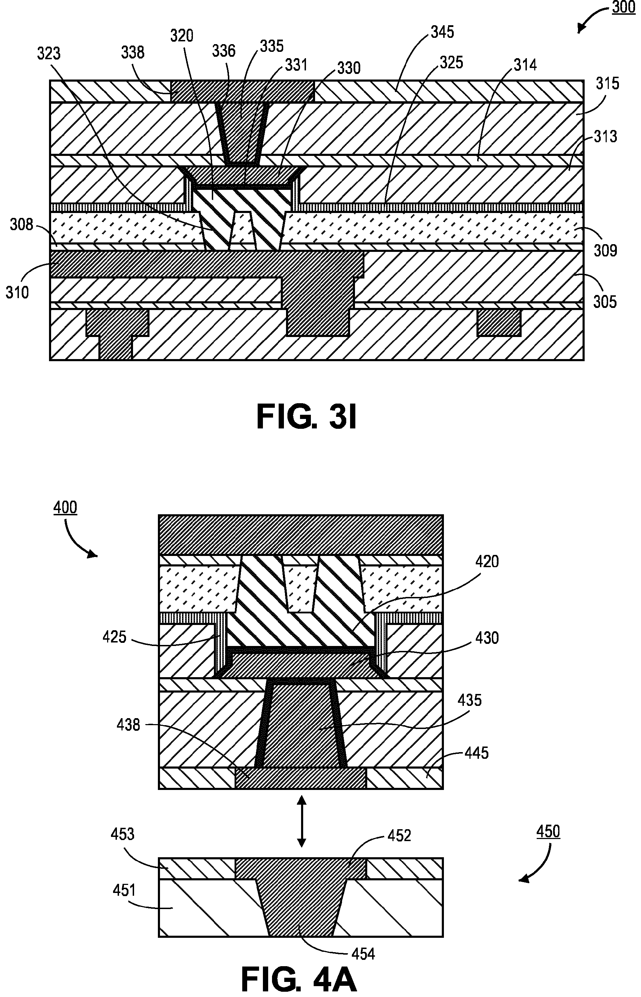

Referring now to Figure 3I, a cross-sectional illustration of the portion of the die 300 after a pad 338 is formed over the via 335 is shown, in accordance with an embodiment. In an embodiment, the pad 338 may comprise copper. For example, a composition of the pad 338 may be similar to a composition of the via 335 and/or a composition of the cap 330. The pad 338 may be formed with any suitable plating and/or patterning process. In an embodiment, a dielectric layer 345 may also be provided over the dielectric layer 315. The dielectric layer 345 may cover sidewalls of the pad 338. In an embodiment, the dielectric layer 345 may be a material suitable for the dielectric-to-dielectric portion of a hybrid bonding process, as will be described in greater detail herein. For example, the dielectric layer 345 may comprise silicon, carbon, and nitrogen (e.g., SiCN).

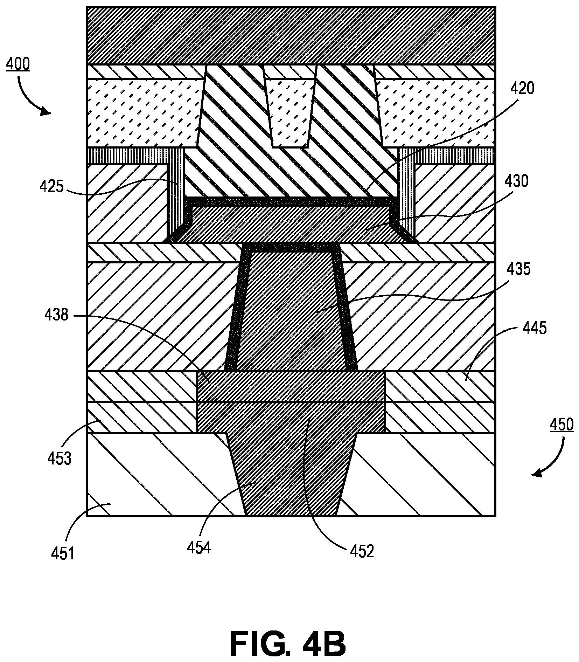

Referring now to Figures 4A and 4B, a pair of cross-sectional illustrations depicting a zoomed in illustration of a die 400 that is hybrid bonded to a package substrate 450 is shown, in accordance with an embodiment. The die 400 may be similar to any of the dies 400 described in greater detail herein. For example, the die 400 may comprise an interconnect that comprises a first pad 420 that comprises aluminum, a cap 430 that comprises copper that is on the first pad 420, a via 435 that comprises copper that is connected to the cap 430, and a second pad 438 that comprises copper that is connected to the via 435. In an embodiment, a passivation layer 425 may be provided along sidewalls of the pad 420 and at least a portion of sidewalls of the cap 430. A dielectric layer 445 may be provided adjacent to the second pad 438. In an embodiment, the package substrate 450 may comprise a dielectric layer 451, such as an organic buildup film or the like. A via 454 may electrically couple a pad 452 to underlying electrical traces (not shown). In an embodiment, a dielectric layer 453 may be provided adjacent to the pad 452. As shown by the arrow, the die 400 and the package substrate 450 may be brought together.

As shown in Figure 4B, the second pad 438 is directly bonded to the pad 452 to provide a copper-to-copper bond. Additionally, the dielectric layer 445 is directly bonded to the dielectric layer 453 to form a dielectric-to-dielectric bond. Accordingly, the die 400 is bonded to package substrate 450 without solder or other intervening interconnect structures.

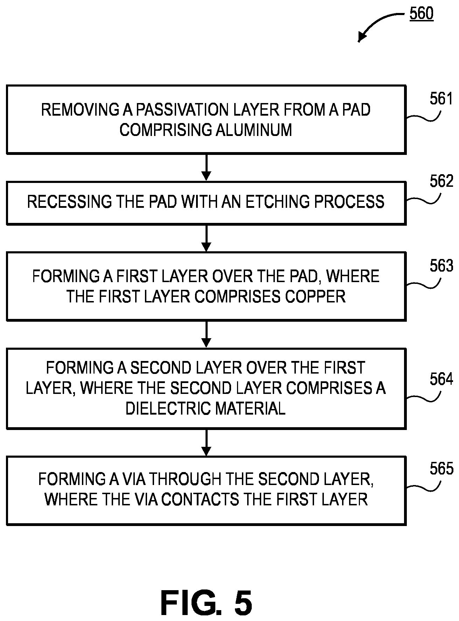

Referring now to Figure 5, a flow diagram depicting a process 560 for forming a die with an interconnect that comprises an aluminum containing pad and a copper containing cap is shown, in accordance with an embodiment. In an embodiment, the process 560 may begin with operation 561, which comprises removing a passivation layer from a pad that comprises aluminum. The pad may comprise substantially all aluminum in some embodiments. The passivation layer may include silicon and nitrogen (e.g., SiN) in some embodiments. The passivation layer may be provided over sidewalls and a top surface of the pad. Removal of the passivation layer may expose a top surface of the pad, while the sidewalls of the pad remain covered by the passivation layer.

In an embodiment, the process 560 may continue with operation 562, which comprises recessing the pad with an etching process. In an embodiment, the etching process may be a dry etching process. A wet clean may follow the dry etch in order to clean any residue from a surface of the pad. The recessing process may result in a substantially planar surface or a non-planar surface. Additionally, the etching process may result in the top surface of the pad being recessed below a top surface of the passivation layer.

In an embodiment, the process 560 may continue with operation 563, which comprises forming a first layer over the pad. In an embodiment, the first layer comprises copper. In some embodiments, the first layer may be similar to structures described as a cap herein. The first layer may include a first width that substantially equals a width of the pad and a second width that is wider than the width of the pad. In an embodiment, at least a portion of a sidewall of the first layer is covered by the passivation layer.

In an embodiment, the process 560 may continue with operation 564, which comprises forming a second layer over the first layer. In an embodiment, the second layer comprises a dielectric material, such as an oxide, a nitride, an oxynitride, and/or the like. In an embodiment, the process 560 may continue with operation 565, which comprises forming a via through the second layer. In an embodiment, the via contacts the first layer. The via may also comprise copper in some embodiment.

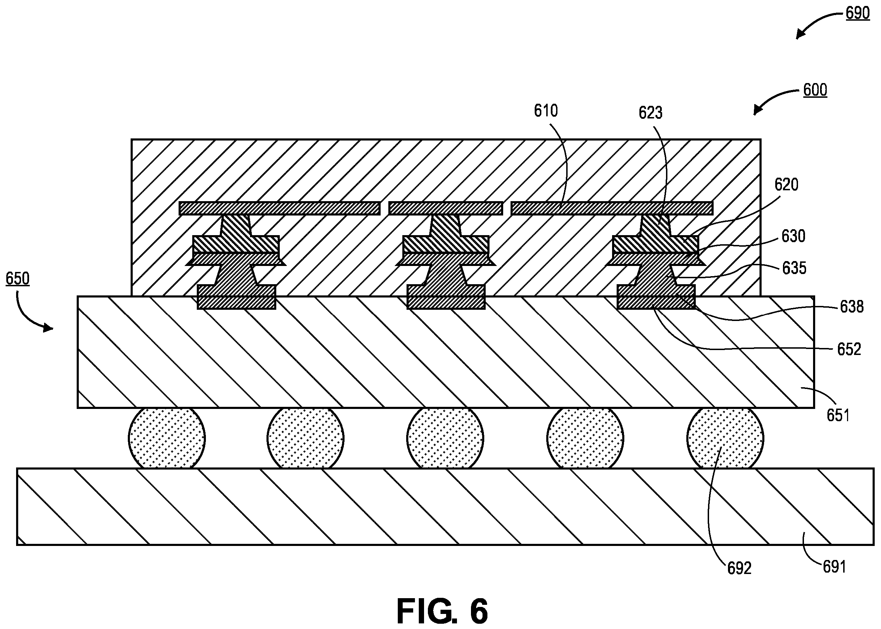

Referring now to Figure 6, a cross-sectional illustration of an electronic system 690 is shown, in accordance with an embodiment. In an embodiment, the electronic system 690 may comprise a board 691. The board 691 may be a printed circuit board (PCB), a motherboard, and/or the like. In an embodiment, the board 691 is coupled to a package substrate 650 by interconnects 692. The interconnects 692 may include any suitable second level interconnect (SLI) architecture. For example, the interconnects 692 may comprise solder balls, sockets, pins, and/or the like.

In an embodiment, the package substrate 650 may comprise one or more dielectric layers 651 with integrated electrical routing (e.g., pads 652, traces, vias, etc.). The package substrate 650 may be cored or coreless. In the case of a cored package substrate, the core (not shown) may be an organic core or a glass core.

In an embodiment, the electronic system 690 may also comprise a die 600. The die 600 may be similar to any of the dies described in greater detail herein. For example, the die 600 may comprise a trace 610 that is coupled to a pad 620 by a via 623. In an embodiment, the pad 620 and the via 623 may comprise aluminum. More particularly, the pad 620 and the via 623 may comprise substantially all aluminum. In another embodiment, the vias 623 may comprise one or more of aluminum, copper, cobalt, or tungsten. In an embodiment, a cap 630 is provided on the pad 620. The cap 630 may comprise copper. In an embodiment, a via 635 may electrically couple the cap 630 to a second pad 638.

In an embodiment, the die 600 may be hybrid bonded to the package substrate 650. The hybrid bonding interface may be similar to the hybrid bonding interface described in greater detail with respect to Figures 4A and 4B. For example, the second pad 638 of the die 600 may be directly bonded to the pad 652 of the package substrate 650. Dielectric layers of the die 600 and the package substrate 650 may also be directly bonded to each other. As such, there may not be solder or other interconnect structures between pads of the die 600 and the package substrate 650 in some embodiments.

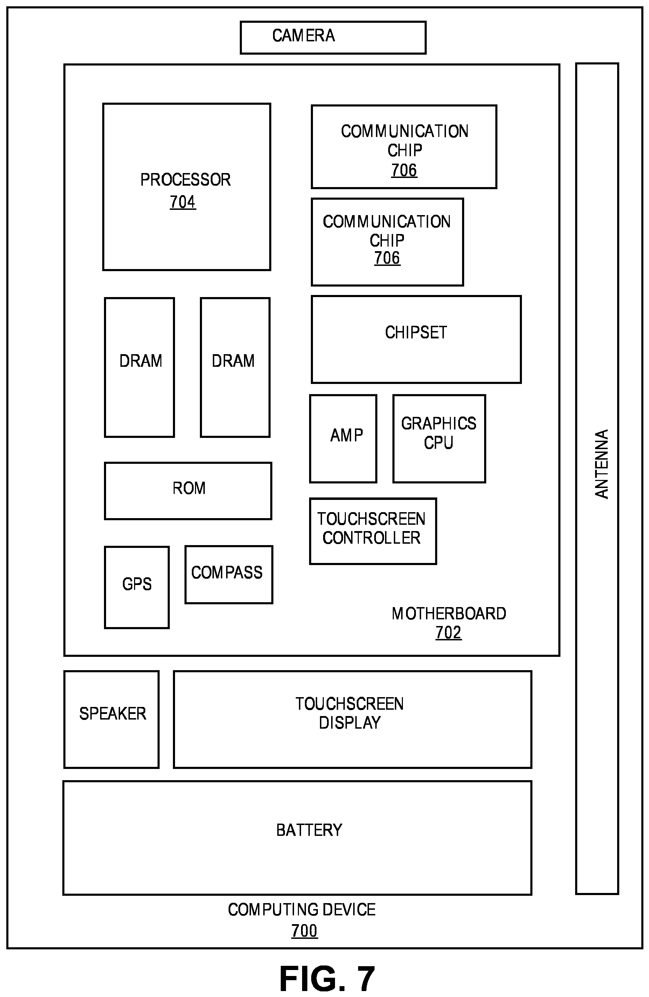

Figure 7 illustrates a computing device 700 in accordance with one implementation of the disclosure. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the disclosure, the integrated circuit die of the processor may be part of an electronic package that comprises a die with an interconnect that comprises an aluminum pad with a copper cap, in accordance with embodiments described herein. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of the disclosure, the integrated circuit die of the communication chip may be part of an electronic package that comprises a die with an interconnect that comprises an aluminum pad with a copper cap, in accordance with embodiments described herein.

In an embodiment, the computing device 700 may be part of any apparatus. For example, the computing device may be part of a personal computer, a server, a mobile device, a tablet, an automobile, or the like. That is, the computing device 700 is not limited to being used for any particular type of system, and the computing device 700 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a pad, wherein the pad comprises aluminum; a liner on a sidewall of the pad, wherein the liner extends past a surface of the pad; a first layer over the pad, wherein the first layer comprises copper; a second layer over the first layer, wherein the second layer is a dielectric material; and a via that passes through the second layer and contacts the first layer.

Example 2: the apparatus of Example 1, wherein a surface of the first layer contacts the liner.

Example 3: the apparatus of Example 1 or Example 2, wherein the first layer has a first width at a first surface and a second width at a second surface that is opposite from the first surface, wherein the first width is greater than the second width.

Example 4: the apparatus of Examples 1-3, wherein the liner comprises silicon and nitrogen.

Example 5: the apparatus of Examples 1-4, wherein the second layer comprises silicon, carbon, and nitrogen.

Example 6: the apparatus of Examples 1-5, wherein an interface between the first layer and the pad is substantially planar.

Example 7: the apparatus of Examples 1-5, wherein an interface between the first layer and the pad is non-planar.

Example 8: the apparatus of Examples 1-7, further comprising: a second via contacting the pad, wherein the second via comprises one or more of aluminum, copper, cobalt, or tungsten.

Example 9: the apparatus of Examples 1-8, wherein the first layer comprises a barrier layer and a bulk layer, wherein the barrier layer comprises one or more of tantalum, nitrogen, or a refractory metal.

Example 10: the apparatus of Examples 1-9, wherein the pad is on a semiconductor substrate.

Example 11: an apparatus, comprising: a package substrate with a first pad; and a die with an interconnect, wherein the interconnect directly contacts the first pad, and wherein the interconnect comprises: a second pad, wherein the second pad comprises aluminum; a cap on the second pad, wherein the cap comprises copper; a via on the cap; and a third pad on the via, wherein the third pad contacts the first pad.

Example 12: the apparatus of Example 11, further comprising: a liner along a sidewall of the second pad and the cap.

Example 13: the apparatus of Example 11 or Example 12, wherein the cap comprises a first width at an interface with the second pad and a second width at a surface contacted by the via, wherein the second width is greater than the first width.

Example 14: the apparatus of Example 13, wherein the second pad comprises a third width, and wherein the first width is substantially equal to the third width.

Example 15: the apparatus of Examples 11-14, further comprising: a layer over the cap, wherein the layer comprises silicon, carbon, and nitrogen.

Example 16: the apparatus of Examples 11-15, wherein the die is hybrid bonded to the package substrate.

Example 17: the apparatus of Examples 11-16, further comprising: a board coupled to the package substrate.

Example 18: an apparatus, comprising: a first layer, wherein the first layer comprises a first dielectric material; a pad in the first layer, wherein the pad comprises aluminum; a cap over the pad and within the first layer, wherein the cap comprises copper; a second layer over the first layer, wherein the second layer comprises a second dielectric material that is different than the first dielectric material; a third layer over the second layer, wherein the third layer comprises the first dielectric material; and a via through the third layer and the second layer, wherein the via contacts the cap.

Example 19: the apparatus of Example 18, wherein the pad has a first width and the cap has a second width, and wherein the second width is greater than the first width.

Example 20: the apparatus of Example 18 or Example 19, further comprising: a liner along a sidewall of the pad and at least a portion of a sidewall of the cap.

## Claims

1. An apparatus, comprising:
a pad, wherein the pad comprises aluminum;
a liner on a sidewall of the pad, wherein the liner extends past a surface of the pad;
a first layer over the pad, wherein the first layer comprises copper;
a second layer over the first layer, wherein the second layer is a dielectric material; and
a via that passes through the second layer and contacts the first layer.

2. The apparatus of claim 1, wherein a surface of the first layer contacts the liner.

3. The apparatus of claim 1 or 2, wherein the first layer has a first width at a first surface and a second width at a second surface that is opposite from the first surface, wherein the first width is greater than the second width.

4. The apparatus of claim 1, 2 or 3, wherein the liner comprises silicon and nitrogen.

5. The apparatus of claim 1, 2, 3 or 4, wherein the second layer comprises silicon, carbon, and nitrogen.

6. The apparatus of claim 1, 2, 3, 4 or 5, wherein an interface between the first layer and the pad is substantially planar.

7. The apparatus of claim 1, 2, 3, 4 or 5, wherein an interface between the first layer and the pad is non-planar.

8. The apparatus of claim 1, 2, 3, 4, 5, 6 or 7, further comprising:
a second via contacting the pad, wherein the second via comprises one or more of aluminum, copper, cobalt, or tungsten.

9. The apparatus of claim 1, 2, 3, 4, 5, 6, 7 or 8, wherein the first layer comprises a barrier layer and a bulk layer, wherein the barrier layer comprises one or more of tantalum, nitrogen, or a refractory metal.

10. The apparatus of claim 1, 2, 3, 4, 5, 6, 7, 8 or 9, wherein the pad is on a semiconductor substrate.

11. A method of fabricating an apparatus, the method comprising:
forming a pad, wherein the pad comprises aluminum;
forming a liner on a sidewall of the pad, wherein the liner extends past a surface of the pad;
forming a first layer over the pad, wherein the first layer comprises copper;
forming a second layer over the first layer, wherein the second layer is a dielectric material; and
forming a via that passes through the second layer and contacts the first layer.

12. The method of claim 11, wherein a surface of the first layer contacts the liner.

13. The method of claim 11 or 12, wherein the first layer has a first width at a first surface and a second width at a second surface that is opposite from the first surface, wherein the first width is greater than the second width.

14. The method of claim 11, 12 or 13, wherein the liner comprises silicon and nitrogen.

15. The method of claim 11, 12, 13 or 14, wherein the second layer comprises silicon, carbon, and nitrogen.
